# EUROPÄISCHE PATENTSCHRIFT

(11) **EP 3 871 448 B1**
(45) Veröffentlichungstag und Bekanntmachung des Hinweises auf die Patenterteilung: **06.12.2023**
(21) Anmeldenummer: 19795523.0
(22) Anmeldetag: 24.10.2019
(51) Int. Cl.: G01R 19/165, H04W 52/02

(54) **SCHALTUNG ZUR AUFBEREITUNG EINES WAKE-UP-SIGNALS**
CIRCUIT FOR PROCESSING A WAKE-UP SIGNAL
CIRCUIT POUR LE TRAITEMENT D'UN SIGNAL DE RÉVEIL

(30) Priorität: 24.10.2018 DE 102018218171
(43) Veröffentlichungstag der Anmeldung: 01.09.2021
(73) Patentinhaber: Robert Bosch GmbH, 70442 Stuttgart (DE)
(72) Erfinder: SCHUMACHER, Hartmut, 71691 Freiberg (DE); KOVACIC, Leonardo, 71665 Vaihingen Enz (DE); WANG, Eugen, 75428 Illingen (DE)
(86) Internationale Anmeldenummer: PCT/EP2019/079069
(87) Internationale Veröffentlichungsnummer: WO 2020/084074

(56) Entgegenhaltungen:
- EP-A1- 1 815 448
- WO-A1-2015/180937
- WO-A1-2017/083831
- US-A1- 2011 317 601
- US-A1- 2014 062 668
- US-B2- 9 565 633

## Beschreibung

Die Erfindung geht aus von einer Schaltung zur Aufbereitung eines Wake-Up-Signals.

Aus dem Stand der Technik bekannte Schaltungen zur Aufbereitung eines sogenannten Wake-Up-Signals werden in der Regel entweder als Bestandteil einer anwendungsspezifischen integrierten Schaltung (ASIC) oder als diskrete Schaltungen entwickelt. Die letzteren lassen sich in analoge und digitale Lösungen unterteilen. Die Aufgabe einer solchen Schaltung zur Aufbereitung eines Wake-Up-Signals besteht darin, die Signale am Eingang der Schaltung auf Gültigkeit zu prüfen, welche zum Aktivieren bzw. Aufwecken von elektrischen Geräten, wie beispielsweise Steuergeräte verwendet werden. So werden nur Signale mit einer bestimmten Amplitude bzw. zeitlichen Dauer als gültig erkannt. Das bedeutet, dass nur im Falle eines gültigen Wake-Up-Signals eine korrespondierende Weckanforderung bzw. ein korrespondierendes aufbereitetes Wake-Up-Signal an die nachfolgende elektrischen Geräte ausgegeben werden. Wird also das anliegende Wake-Up-Signal nicht als gültig erkannt, dann werden die elektrischen Geräte nicht aktiviert.

Die bekannten Schaltungen zur Aufbereitung eines Wake-Up-Signals besitzen fest eingestellte und unveränderbare Parameter für die vorgegebenen Kriterien zur Überprüfung des anliegenden Wake-Up-Signals. Ferner lassen sich diese Schaltungen nicht abschalten bzw. deaktivieren oder benötigen zusätzliche Schutzelemente, um in einem Fahrzeug direkt an Wake-Up-Leitungen angeschlossen werden zu können. Zudem enthalten diese Schaltungen typischerweise einen Komparator, der beim Überschreiten einer bestimmten Schwelle die nachfolgenden elektrischen Geräte aktiviert bzw. aufweckt.

Aus der US 2011/0317601 A1 ist ein Verfahren zum Aufwecken der Stromversorgung einer fernverwalteten Digitalanzeige bekannt, welches nachfolgende Schritte umfasst: Bereitstellen eines Detektors zum Erfassen einer Hüllkurve eines digitalen Signals. Empfangen eines Pakets mit erweiterbarer Länge, welches aus einem gleichen, wiederholten Datensymbol besteht. Erkennen, dass das Paket mit erweiterter Länge vom Detektor empfangen wurde, um ein Ausgangssignal bereitzustellen, wobei das Ausgangssignal mit einer Referenzschwelle verglichen wird und ein Aufwecksignal bereitgestellt wird, wenn das Ausgangssignal die Referenzschwelle überschreitet. Anschließend können Informationen empfangen werden, welche auf der fernverwalteten Digitalanzeige angezeigt werden können.

Aus der US 9,565,633 B2 ist eine Aufweckschaltung bekannt, die konfiguriert ist, um ein Aufwecksignal von einem drahtlosen Endgerät zu erfassen, wobei das Aufwecksignal ein moduliertes Wellenformsignal enthält. Zudem ist ein schaltbares Kommunikationsmodul vorgesehen, welche konfiguriert ist, basierend auf einem Steuersignal, welches von der Aufweckschaltung erzeugt wird, von einem Schlafmodus, in dem das Kommunikationsmodul nicht für die Kommunikation mit dem drahtlosen Endgerät betreibbar ist, in einen aktiven Modus geschaltet zu werden, in welchem das Kommunikationsmodul für die Kommunikation mit dem drahtlosen Endgerät betreibbar ist. Ein drahtloses Endgerät umfasst eine erste drahtlose Kommunikationsschnittstelle, die für die Kommunikation mit einem Gerät unter Verwendung eines drahtlosen Kommunikationsprotokolls konfiguriert ist, eine zweite drahtlose Kommunikationsschnittstelle, die für die drahtlose Kommunikation mit einem drahtlosen Zugangsknoten eines drahtlosen Netzwerks konfiguriert ist, und einen Prozessor, der konfiguriert ist, um die Weiterleitung von Informationen zwischen dem Endgerät und dem drahtlosen Zugangsknoten des drahtlosen Netzwerks zu unterstützen.

Aus der WO 2017/083831 A1 ist eine Schaltung zur Aufbereitung eines Wake-Up-Signals bekannt, welches zur Aktivierung von elektrischen Geräten verwendbar ist. Die Schaltung umfasst eine Bewertungsschaltung, welche ein anliegendes Wake-Up-Signal auf seine Gültigkeit überprüft, und eine Ausgangstreiberschaltung, welche ein aufbereitetes Wake-Up-Signal ausgibt, wenn die Bewertungsschaltung das anliegende Wake-Up-Signal als gültig bewertet. Die Bewertungsschaltung umfasst einen Komparator, welcher das anliegende Wake-Up-Signal zur Bewertung mit mindestens einem Schwellwert vergleicht. Zudem umfasst die Bewertungsschaltung eine Eingangsschaltung und eine schaltbare Konstantspannungsquelle, über welche jeweils mindestens ein Kriterium zur Bewertung des anliegenden Wake-Up-Signals einstellbar ist, wobei der Komparator als mehrkanalige integrierte Komparatorschaltung ausgeführt ist. Die einzelnen Kanäle der integrierten Komparatorschaltung bewerten jeweils ein Kriterium des anliegenden Wake-Up-Signals, wobei die mehrkanalige integrierte Komparatorschaltung eine interne Spannungsquelle umfasst, welche eine Referenzspannung erzeugt. Ein am Eingang eines ersten Kanals der mehrkanaligen integrierten Komparatorschaltung anliegendes erstes Spannungssignal wird mit der Referenzspannung verglichen, wobei ein erstes Kriterium erfüllt ist, wenn das erste Spannungssignals größer als die Referenzspannung ist. Ein am Eingang eines zweiten Kanals der mehrkanaligen integrierten Komparatorschaltung anliegendes zweites Spannungssignal wird mit der Referenzspannung verglichen, wobei ein zweites Kriterium erfüllt ist, wenn das zweite Spannungssignal größer als die Referenzspannung ist.

### Offenbarung der Erfindung

Die Schaltung zur Aufbereitung eines Wake-Up-Signals mit den Merkmalen des unabhängigen Patentanspruchs 1 hat den Vorteil, dass durch den Einsatz einer mehrkanaligen integrierten Komparatorschaltung, einer diskreten Eingangsschaltung und einer schaltbaren diskreten Konstantspannungsquelle Eingangsparameter der Schaltung, wie beispielsweise eine Eingangsimpedanz, und Kriterien zur Bewertung des anliegenden Wake-Up-Signals durch die Variation der Bauteilwerte in der Eingangsschaltung und/oder in der Konstantspannungsquelle einfach eingestellt werden können. Zudem können diese Eingangsparameter und Kriterien für einen Einsatz in Kraftfahrzeugen sehr präzise und stabil über einen weiten Spannungs- und Temperaturbereich vorgegeben werden. Dies wird durch den hohen Eingangswiderstand der mehrkanaligen integrierten Komparatorschaltung bewirkt, durch welchen eine hochohmige Entkopplung der Leitung des Wake-Up-Signals von der restlichen Schaltung erreicht werden kann. Damit lässt sich ein sehr weites Spektrum an Kundenanforderungen abdecken, ohne dass eine Überarbeitung des Layouts der Schaltung notwendig wäre. Zudem kann die Spannungsversorgung der Konstantspannungsquelle nur bei einem tatsächlich anliegenden Wake-Up-Signal zugeschaltet werden. Dadurch sind Ausführungsformen der erfindungsgemä-ßen Schaltung zur Aufbereitung eines Wake-Up-Signals im Ruhezustand bis auf die mehrkanaligen integrierte Komparatorschaltung komplett inaktiv und zeichnen sich deswegen durch einen sehr niedrigen, für dauerversorgte Systeme geeigneten Stromverbrauch aus. Der Einsatz der mehrkanaligen integrierten Komparatorschaltung ermöglicht einen relativ kompakten Aufbau der Schaltung, da nur wenige externe Bauteile benötigt werden. Der Einsatz einer permanent aktiven und geregelten Spannungsversorgung sowie einer Taktquelle ist nicht erforderlich.

Ausführungsformen der vorliegenden Erfindung stellen eine Schaltung zur Aufbereitung eines Wake-Up-Signals zur Verfügung, welches zur Aktivierung von elektrischen Geräten verwendbar ist. Die Schaltung zur Aufbereitung eines Wake-Up-Signals umfasst eine Bewertungsschaltung, welche ein anliegendes Wake-Up-Signal auf seine Gültigkeit überprüft, und eine Ausgangstreiberschaltung, welche ein aufbereitetes Wake-Up-Signal ausgibt, wenn die Bewertungsschaltung das anliegende Wake-Up-Signal als gültig bewertet. Die Bewertungsschaltung umfasst einen Komparator, welcher das anliegende Wake-Up-Signal zur Bewertung mit mindestens einem Schwellwert vergleicht. Hierbei umfasst die Bewertungsschaltung eine Eingangsschaltung und eine schaltbare Konstantspannungsquelle, über welche jeweils mindestens ein Kriterium zur Bewertung des anliegenden Wake-Up-Signals einstellbar ist, wobei der Komparator als mehrkanalige integrierte Komparatorschaltung ausgeführt ist, und wobei die einzelnen Kanäle der integrierten Komparatorschaltung jeweils ein Kriterium des anliegenden Wake-Up-Signals bewerten.

Hierbei umfasst die mehrkanalige integrierte Komparatorschaltung eine interne Spannungsquelle, welche eine Referenzspannung erzeugt. Zudem wird ein am Eingang eines ersten Kanals der mehrkanaligen integrierten Komparatorschaltung anliegendes erstes Spannungssignal, welches die Amplitude des anliegenden Wake-Up-Signals repräsentiert, mit der Referenzspannung verglichen, wobei das erste Kriterium erfüllt ist, wenn das erste Spannungssignals größer als die Referenzspannung ist. Hierbei kann das heruntergeteilte Wake-Up-Signal am nichtinvertierenden Eingang des ersten Kanals anliegen und die interne Referenzspannung kann an einem internen invertierenden Eingang des ersten Kanals anliegen, welcher vorzugsweise von außen nicht zugänglich ist, um die Anzahl von Anschlusspins an der integrierten Komparatorschaltung zu reduzieren. Des Weiteren wird ein am Eingang eines zweiten Kanals der mehrkanaligen integrierten Komparatorschaltung anliegendes zweites Spannungssignal, welches die Zeitdauer des anliegenden Wake-Up-Signals repräsentiert, mit der Referenzspannung verglichen, wobei das zweite Kriterium erfüllt ist, wenn das zweite Spannungssignal größer als die Referenzspannung ist. Hierbei kann das über dem mindestens einen Kondensator der RC-Schaltung anliegende Ausgangssignal der Konstantspannungsquelle als zweites Spannungssignal am invertierenden Eingang des zweiten Kanals anliegen und die interne Referenzspannung kann an einem internen nichtinvertierenden Eingang des zweiten Kanals anliegen, welcher vorzugsweise von außen nicht zugänglich ist, um die Anzahl von Anschlusspins an der integrierten Komparatorschaltung zu reduzieren.

Des Weiteren ändert die mehrkanalige integrierte Komparatorschaltung einen Zustand am Ausgang des ersten Kanals, wenn das erste Kriterium erfüllt ist, wobei die Zustandsänderung am Ausgang des ersten Kanals die Bewertung des zweiten Kriteriums startet. So kann der Ausgang des ersten Kanals beispielsweise seinen aktiven "Low" Zustand in einen "High Impedance" Zustand ändern. Dies kann beispielsweise durch einen sogenannten Open-Kollektor-Ausgang des Komparators umgesetzt werden. Durch den Zustandswechsel des Ausgangs des ersten Kanals kann der mindestens eine Kondensator über den Ladewiderstand mit der Ladespannung aufgeladen werden.

Durch die in den abhängigen Ansprüchen aufgeführten Maßnahmen und Weiterbildungen sind vorteilhafte Verbesserungen der im unabhängigen Patentanspruch 1 angegebenen Schaltung zur Aufbereitung eines Wake-Up-Signals möglich.

Besonders vorteilhaft ist, dass die Eingangsschaltung über ein einstellbares Teilungsverhältnis eines Spannungsteilers ein erstes Kriterium zur Bewertung einer Amplitude des anliegenden Wake-Up-Signals vorgibt. Zudem kann die Eingangsschaltung eine Eingangsimpedanz der Bewertungsschaltung vorgeben. Durch den Spannungsteiler wird das Wake-Up-Signal zunächst heruntergeteilt und durch Verwendung eines zusätzlichen Filterkondensators on schnellen transienten Störsignalen befreit. Über das einstellbare Teilungsverhältnis des Spannungsteilers kann eine Amplitudenerkennungsschwelle als erstes Kriterium eingestellt werden. Durch das Verändern des Teilungsverhältnisses kann die Amplitudenerkennungsschwelle einfach an entsprechende Kundenanforderungen angepasst werden. Durch geeignete Wahl des Innenwiderstandes der Eingangsschaltung, welcher sich aus den Werten der Widerstände des Spannungsteilers ergibt, zusammen mit dem Kapazitätswert des Filterkondensators können transiente Störungen, welche eine stabile Amplitudenerkennung erschweren, beseitigt werden.

In vorteilhafter Ausgestaltung der Schaltung kann die schaltbare Konstantspannungsquelle über eine einstellbare Zeitkonstante einer RC-Schaltung ein zweites Kriterium zur Bewertung einer Zeitdauer des anliegenden Wake-Up-Signals vorgeben. Zudem kann das anliegende Wake-Up-Signal die Konstantspannungsquelle einschalten. Die Zeitkonstante der RC-Schaltung als zweites Kriterium kann einfach durch Verändern des Wertes eines Ladewiderstands und/oder mindestens eines Kondensators der RC-Schaltung an entsprechende Kundenanforderungen angepasst werden. Um eine Unabhängigkeit des zweiten Kriteriums von der Spannungsversorgung der Schaltung zu gewährleisten, kann eine Ladespannung des mindestens einen Kondensators der RC-Schaltung beispielsweise durch eine Zenerdiode auf einen vorgegebenen Wert von beispielsweise 2,7V stabilisiert werden. Um einen permanenten Stromverbrauch der Konstantspannungsquelle zu verhindern, wird diese beispielsweise über einen Transistor nur dann zugeschaltet, wenn tatsächlich ein Wake-Up-Signal am Eingang der Bewertungsschaltung anliegt. Dies ermöglicht eine Reduzierung des Ruhestromverbrauchs der Schaltung auf wenige Mikroampere. Da die Energie zum Aufladen des mindestens einen Kondensators nur dann aus der Energiequelle des Fahrzeugs entnommen wird, wenn ein gültiges Wake-Up-Signal vorliegt. Auf diese Weise ist eine weitgehende Entkopplung des Wake-Up-Signals möglich, was eine konstante und versorgungsunabhängige Impedanz des Eingangs der Schaltung ermöglicht. Damit eignet sich Ausführungsformen der erfindungsgemäßen Schaltung für Sleep Systeme die an einer Dauerversorgung angeschlossen sind und im schlafenden Zustand, d.h. im nicht aktiven Zustand, Stromanforderungen von weniger als 100µA erfüllen müssen.

In weiterer vorteilhafter Ausgestaltung der Schaltung kann die mehrkanalige integrierte Komparatorschaltung einen Zustand am Ausgang des zweiten Kanals ändern, wenn das zweite Kriterium erfüllt ist, wobei die Zustandsänderung am Ausgang des zweiten Kanals die Ausgangstreiberschaltung aktivieren kann. So kann der Ausgang des zweiten Kanals beispielsweise seinen "High Impedance" Zustand auf einen aktiv "Low" Zustand ändern. Da auch hier ein Open-Kollektor-Ausgang verwendet wird, wird der Ausgang des zweiten Kanals auf Massepotential gezogen. Durch diesen Zustandswechsel des Ausgangs des zweiten Kanals wird die Ausgangstreiberschaltung aktiviert, so dass diese das aufbereitete Wake-Up-Signal ausgibt, welches nachfolgende elektrische Geräte aktiviert bzw. aufweckt.

Ein Ausführungsbeispiel der Erfindung ist in der Zeichnung dargestellt und wird in der nachfolgenden Beschreibung näher erläutert. In der Zeichnung bezeichnen gleiche Bezugszeichen Komponenten bzw. Elemente, die gleiche bzw. analoge Funktionen ausführen.

Kurze Beschreibung der Zeichnungen
Fig. 1 zeigt eine schematische Blockdiagramm eines Ausführungsbeispiels einer erfindungsgemäßen Schaltung zur Aufbereitung eines Wake-Up-Signals.
Fig. 2 zeigt ein Schaltbild der erfindungsgemäßen Schaltung zur Aufbereitung eines Wake-Up-Signals aus Fig. 1.

### Ausführungsformen der Erfindung

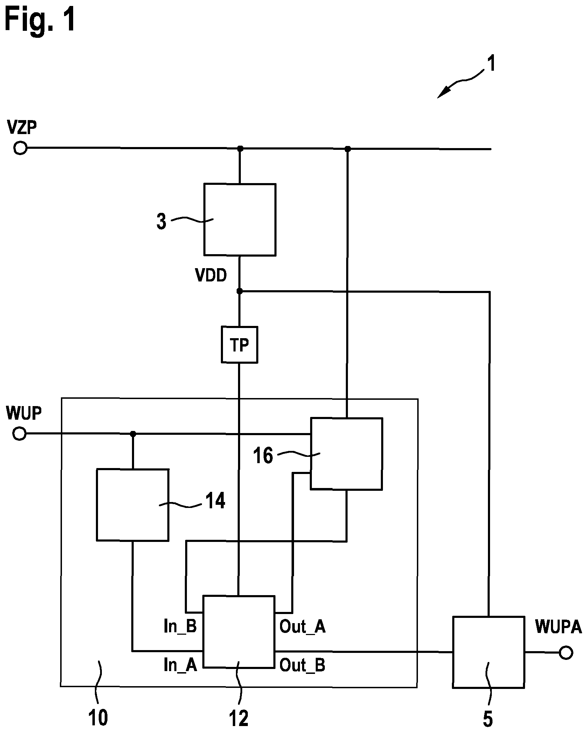

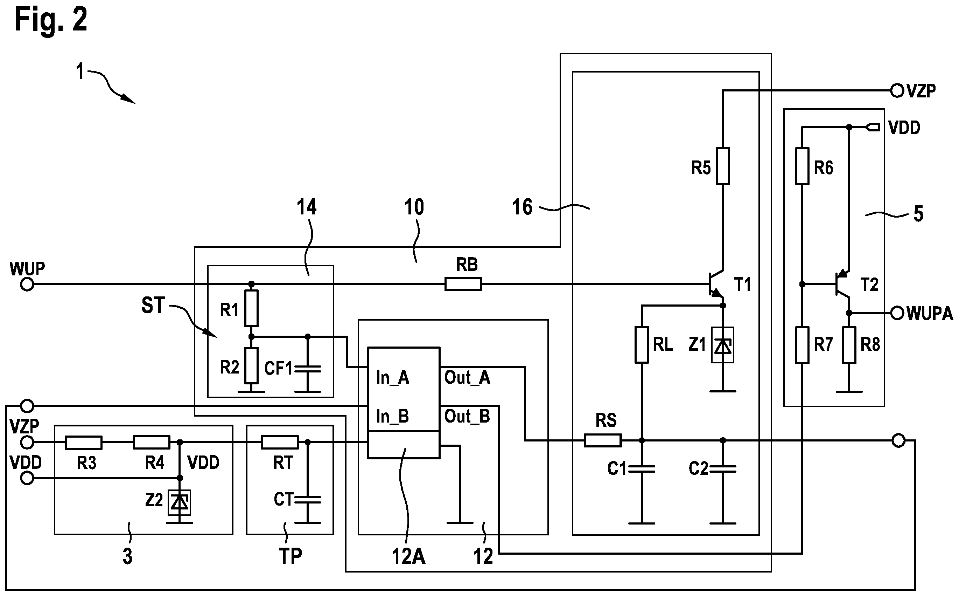

Wie aus Fig. 1 und 2 ersichtlich ist, umfasst das dargestellte Ausführungsbeispiel einer erfindungsgemäßen Schaltung 1 zur Aufbereitung eines Wake-Up-Signals WUP, welches zur Aktivierung von elektrischen Geräten verwendbar ist, eine Bewertungsschaltung 10, welche ein anliegendes Wake-Up-Signal WUP auf seine Gültigkeit überprüft, und eine Ausgangstreiberschaltung 5, welche ein aufbereitetes Wake-Up-Signal WUPA ausgibt, wenn die Bewertungsschaltung 10 das anliegende Wake-Up-Signal WUP als gültig bewertet. Die Bewertungsschaltung 10 umfasst einen Komparator 12, welcher das anliegende Wake-Up-Signal WUP zur Bewertung mit mindestens einem Schwellwert vergleicht. Hierbei umfasst die Bewertungsschaltung 10 eine Eingangsschaltung 14 und eine schaltbare Konstantspannungsquelle 16, über welche jeweils mindestens ein Kriterium zur Bewertung des anliegenden Wake-Up-Signals WUP einstellbar ist. Zudem ist der Komparator 12 als mehrkanalige integrierte Komparatorschaltung 12A ausgeführt, wobei die einzelnen Kanäle der integrierten Komparatorschaltung 12A jeweils ein Kriterium des anliegenden Wake-Up-Signals WUP bewerten.

Im dargestellten Ausführungsbeispiel gibt die Eingangsschaltung 14 über ein einstellbares Teilungsverhältnis eines Spannungsteilers ST ein erstes Kriterium zur Bewertung einer Amplitude des anliegenden Wake-Up-Signals WUP vor. Zudem gibt die Eingangsschaltung 14 über eine entsprechende Dimensionierung der einzelnen ohmschen Widerstände R1 und R2 des Spannungsteilers ST eine Eingangsimpedanz der Bewertungsschaltung 10 vor. Die schaltbare Konstantspannungsquelle 16 gibt über eine einstellbare Zeitkonstante einer RC-Schaltung RL, C1, C2 ein zweites Kriterium zur Bewertung einer Zeitdauer des anliegenden Wake-Up-Signals WUP vor.

Wie aus Fig. 1 und 2 weiter ersichtlich ist, schaltet das anliegende Wake-Up-Signal WUP die Konstantspannungsquelle 16 über einen ohmschen Widerstand RB ein, welcher im dargestellten Ausführungsbeispiel mit einer Basis eines Schalttransistors T1 verbunden ist.

Im dargestellten Ausführungsbeispiel ist der Komparator 12 als zweikanalige integrierte Komparatorschaltung 12A ausgeführt, welche eine nicht näher bezeichnete interne Spannungsquelle umfasst und dessen Ausgänge Out_A und Out_B als sogenannte Open-Kollektor-Ausgänge ausgeführt sind. Die interne Spannungsquelle erzeugte eine Referenzspannung von beispielsweise 400mV. Hierbei wird ein am Eingang In_A des ersten Kanals der mehrkanaligen integrierte Komparatorschaltung 12A anliegendes erstes Spannungssignal, welches die Amplitude des anliegenden Wake-Up-Signals WUP repräsentiert, mit der Referenzspannung verglichen, wobei das erste Kriterium erfüllt ist, wenn das erste Spannungssignals größer als die Referenzspannung ist. Des Weiteren wird ein am Eingang ln_B des zweiten Kanals der mehrkanaligen integrierte Komparatorschaltung 12A anliegendes zweites Spannungssignal, welches die Zeitdauer des anliegenden Wake-Up-Signals WUP repräsentiert, mit der Referenzspannung verglichen, wobei ein Zeitkriterium als zweites Kriterium erfüllt ist, wenn das zweite Spannungssignal größer als die Referenzspannung ist.

Wie aus Fig. 2 weiter ersichtlich ist, wird das anliegende Wake-Up-Signal WUP zunächst vom Spannungsteiler ST der Eingangsschaltung 14 heruntergeteilt und durch Verwendung eines Filterkondensators CF von schnellen transienten Störsignalen befreit. Über das Teilungsverhältnis des Spannungsteilers ST der Eingangsschaltung 14 wird eine Amplitudenerkennungsschwelle als erstes Kriterium zur Bewertung des Wake-Up-Signals WUP eingestellt und kann durch das Verändern der Werte der beiden ohmschen Widerstände R1, R2 leicht an entsprechende Kundenanforderungen angepasst werden. Durch geeignete Wahl des Innenwiderstandes der Eingangsschaltung zusammen mit dem Kapazitätswert des Filterkondensators CF können transiente Störungen, welche eine stabile Amplitudenerkennung erschweren, beseitigt werden. Das heruntergeteilte Wake-Up-Signal WUP ist mit einem nichtinvertierenden Eingang In_A des ersten Kanals verbunden. Die interne Spannungsquelle ist mit einem invertierenden Eingang des ersten Kanals verbunden, welcher nicht von au-ßen zugänglich ist. Überschreitet das heruntergeteilte Wake-Up-Signal WUP bzw. das erste Spannungssignal am nichtinvertierenden Eingang In_A des ersten Kanals der zweikanaligen integrierten Komparatorschaltung 12A die interne Referenzspannung von 400mV, so wird ein vorgegebenes Amplitudenkriterium des Wake-Up-Signals WUP erfüllt und ein Ausgang Out_A des ersten Kanals der zweikanaligen integrierten Komparatorschaltung 12A wechselt seinen Zustand von aktiv "Low" auf "High Impedance". Dadurch werden die über einen ohmschen Schutzwiderstand RS mit dem Ausgang Out_A des ersten Kanals verbundenen Kondensatoren C1 und C2 der RC-Schaltung über einen Ladewiderstand RL der RC-Schaltung aufgeladen.

Wie aus Fig. 2 weiter ersichtlich ist, umfasst die RC-Schaltung im dargestellten Ausführungsbeispiel zwei parallel geschaltete Kondensatoren C1 und C2. Die Spannung über den Kondensatoren C1 und C2 liegt gleichzeitig als zweites Spannungssignal an einem invertierenden Eingang In_B des zweiten Kanals der zweikanaligen integrierten Komparatorschaltung 12A an. Die interne Spannungsquelle ist mit einem nichtinvertierenden Eingang des zweiten Kanals verbunden, welcher nicht von außen zugänglich ist. Erreicht das zweite Spannungssignal die interne Referenzspannung von 400mV, dann ist zusätzlich zum Amplitudenkriterium das Zeitkriterium erfüllt und der Ausgang Out_B des zweiten Kanals der zweikanaligen integrierten Komparatorschaltung 12A wechselt seinen Zustand von "High Impedance" auf aktiv "Low". Da auch hier ein Open-Kollektor-Ausgang verwendet wird, zieht die Ausgangstreiberschaltung 5 einen Anschlusspin des Ausgangs Out_B des zweiten Kanals auf Massepotential. Liegt das Wake-Up-Signal WUP nicht mehr an der Bewertungsschaltung 10 an bzw. wird das Amplitudenkriterium nicht mehr erfüllt, dann wechselt der Ausgang Out_A des ersten Kanals der zweikanaligen integrierten Komparatorschaltung 12A seinen Zustand von "High Impedance" auf aktiv "Low", so dass die beiden Kondensatoren C1 und C2 über den Schutzwiderstand RS und diesen Ausgang Out_A schnell entladen werden können. Dieses Verhalten verhindert das mögliche "Aufaddieren" der Ladungen in den beiden Kondensatoren C1 und C2 bei mehreren aufeinander folgenden Wake-Up-Signalen, welche nur durch kurze Pausen voneinander getrennt sind. Das Zeitkriterium kann leicht durch eine Veränderung der Zeitkonstante über die Werte der beiden Kondensatoren C1 und C2 und des Ladewiderstands RL auf entsprechende Kundenanforderungen angepasst werden.

Wie aus Fig. 2 weiter ersichtlich ist, wird die Ladespannung der Kondensatoren C1 und C2 durch eine Zenerdiode Z1 und einen ohmschen Widerstand R5 auf beispielsweise 2,7V stabilisiert. Alternativ kann in der Konstantspannungsquelle 16 eine andere Spannungsstabilisierung zum Laden der Kondensatoren C1 und C2 verwendet werden. So kann beispielsweise eine abgeglichene Band-Gap-Spannungsreferenz anstatt der Zenerdiode Z1 verwendet werden, falls eine höhere Genauigkeit des Zeitkriteriums gefordert wird. Um einen permanenten Stromverbrauch der Konstantspannungsquelle 16 zu verhindern, wird diese über den Schalttransistor T1 nur dann zugeschaltet, wenn tatsächlich ein Wake-Up-Signal WUP am Eingang der Bewertungsschaltung 10 anliegt. Dies ermöglicht eine Reduzierung des Ruhestromverbrauchs der Bewertungsschaltung 10 auf wenige Mikroampere. Die Energie zum Aufladen der Kondensatoren C1 und C2 wird nur dann aus einer verpolgeschützten Dauerversorgung VZP einer nicht dargestellten Fahrzeugbatterie entnommen, wenn ein Wake-Up-Signal WUP anliegt. Auf diese Weise ist eine weitgehende Entkopplung des Wake-Up-Signals WUP möglich, was eine konstante und versorgungsunabhängige Impedanz des Eingangs der Bewertungsschaltung 10 ermöglicht.

Ist sowohl das Amplitudenkriterium als auch Zeitkriterium erfüllt, dann wird das aufbereitete Wake-Up-Signal WUPA am Ausgang der Ausgangstreiberschaltung 5 über einen Treibertransistor T2 und einen ohmschen Widerstand R8 annähernd auf das Potential einer Versorgungsspannung VDD gebracht. Dabei wird der Treibertransistor T2 durch den aktiven "Low" Zustand des Ausgangs Out_B des zweiten Kanals der zweikanaligen integrierten Komparatorschaltung 12A angesteuert, wobei ein Arbeitspunkt des Treibertransistors T2 über einen Basisspannungsteiler aus zwei ohmschen Widerständen R6 und R7 einstellbar ist.

Zur optimalen Versorgung der zweikanaligen integrierten Komparatorschaltung 12A erfolgt eine Anbindung eines Versorgungsanschlusses VDD der Komparatorschaltung 12A über eine Schutzschaltung 5, welche die Versorgungsspannung VDD der zweikanaligen integrierten Komparatorschaltung 12A und der Ausgangstreiberschaltung 5 begrenzt. Die Schutzschaltung 3 umfasst im dargestellten Ausführungsbeispiel zwei in Reihe geschaltete ohmsche Widerstände R3 und R4 und eine weitere Zenerdiode Z2, welche die Versorgungsspannung VDD aus der verpolgeschützten Dauerversorgung VZP des Fahrzeugs abklammert. Im üblichen Spannungsbereich bei abgestelltem Fahrzeug (Motor aus) der Dauerversorgung VZP im Bereich von 5V bis 13,8V wird nahezu kein Strom durch die Schutzschaltung 3 nach Masse abgeführt und damit hat auch dieser Schaltungsteil keinen Einfluss auf die Sleep Stromanforderungen für die verpolgeschützte Dauerversorgung VZP des Fahrzeugs. Ein nachgeschalteter Tiefpass TP, welcher einen ohmschen Widerstand RT und einen Kondensator CT umfasst, filtert zusätzlich die Versorgungsspannung VDD der zweikanaligen integrierten Komparatorschaltung 12A mit einer einstellbaren Eckfrequenz von beispielsweise 600Hz, um Störungen von der zweikanaligen integrierten Komparatorschaltung 12A fernzuhalten und damit die Güte der Wake-Up-Signaldiskriminierung nach Amplitude und Zeit zu optimieren.

## Patentansprüche

1. Schaltung (1) zur Aufbereitung eines Wake-Up-Signals (WUP), welches zur Aktivierung von elektrischen Geräten verwendbar ist, mit einer Bewertungsschaltung (10), welche ein anliegendes Wake-Up-Signal (WUP) auf seine Gültigkeit überprüft, und einer Ausgangstreiberschaltung (5), welche ein aufbereitetes Wake-Up-Signal (WUPA) ausgibt, wenn die Bewertungsschaltung (10) das anliegende Wake-Up-Signal (WUP) als gültig bewertet, wobei die Bewertungsschaltung (10) einen Komparator (12) umfasst, welcher das anliegende Wake-Up-Signal (WUP) zur Bewertung mit mindestens einem Schwellwert vergleicht, wobei die Bewertungsschaltung (10) eine Eingangsschaltung (14) und eine schaltbare Konstantspannungsquelle (16) umfasst, über welche jeweils mindestens ein Kriterium zur Bewertung des anliegenden Wake-Up-Signals (WUP) einstellbar ist, wobei der Komparator (12) als mehrkanalige integrierte Komparatorschaltung (12A) ausgeführt ist, wobei die einzelnen Kanäle der integrierten Komparatorschaltung (12A) jeweils ein Kriterium des anliegenden Wake-Up-Signals (WUP) bewerten, wobei die mehrkanalige integrierte Komparatorschaltung (12A) eine interne Spannungsquelle umfasst, welche eine Referenzspannung erzeugt, wobei ein am Eingang (In_A) eines ersten Kanals der mehrkanaligen integrierten Komparatorschaltung (12A) anliegendes erstes Spannungssignal, welches die Amplitude des anliegenden Wake-Up-Signals (WUP) repräsentiert, mit der Referenzspannung verglichen wird, wobei ein erstes Kriterium erfüllt ist, wenn das erste Spannungssignals größer als die Referenzspannung ist, und wobei ein am Eingang (ln_B) eines zweiten Kanals der mehrkanaligen integrierten Komparatorschaltung (12A) anliegendes zweites Spannungssignal, welches die Zeitdauer des anliegenden Wake-Up-Signals (WUP) repräsentiert, mit der Referenzspannung verglichen wird, wobei ein zweites Kriterium erfüllt ist, wenn das zweite Spannungssignal größer als die Referenzspannung ist, **dadurch gekennzeichnet, dass** die mehrkanalige integrierte Komparatorschaltung (12A) einen Zustand am Ausgang (Out_A) des ersten Kanals ändert, wenn das erste Kriterium erfüllt ist, und wobei die Zustandsänderung am Ausgang (Out_A) des ersten Kanals die Bewertung des zweiten Kriteriums startet.

2. Schaltung (1) nach Anspruch 1, **dadurch gekennzeichnet, dass** die Eingangsschaltung (14) über ein einstellbares Teilungsverhältnis eines Spannungsteilers (ST) das erste Kriterium zur Bewertung einer Amplitude des anliegenden Wake-Up-Signals (WUP) vorgibt.

3. Schaltung (1) nach Anspruch 1 oder 2, **dadurch gekennzeichnet, dass** die Eingangsschaltung (14) eine Eingangsimpedanz der Bewertungsschaltung (10) vorgibt.

4. Schaltung (1) nach einem der Ansprüche 1 bis 3, **dadurch gekennzeichnet, dass** die schaltbare Konstantspannungsquelle (16) über eine einstellbare Zeitkonstante einer RC-Schaltung (RL, C1, C2) das zweite Kriterium zur Bewertung einer Zeitdauer des anliegenden Wake-Up-Signals (WUP) vorgibt.

5. Schaltung (1) nach Anspruch 4, **dadurch gekennzeichnet, dass** das anliegende Wake-Up-Signal (WUP) die Konstantspannungsquelle (16) einschaltet.

6. Schaltung (1) nach einem der Ansprüche 1 bis 5, **dadurch gekennzeichnet, dass** die mehrkanalige integrierte Komparatorschaltung (12A) einen Zustand am Ausgang (Out_B) des zweiten Kanals ändert, wenn das zweite Kriterium erfüllt ist, wobei die Zustandsänderung am Ausgang (Out_B) des zweiten Kanals die Ausgangstreiberschaltung (5) aktiviert.

## Claims

1. Circuit (1) for processing a wake-up signal (WUP) which is able to be used to activate electrical devices, having an evaluation circuit (10) which checks the validity of a wake-up signal (WUP) that is present, and an output driver circuit (5) which outputs a processed wake-up signal (WUPA) if the evaluation circuit (10) deems the wake-up signal (WUP) that is present to be valid, wherein the evaluation circuit (10) comprises a comparator (12) which compares the wake-up signal (WUP) that is present for evaluation with at least one threshold value, wherein the evaluation circuit (10) comprises an input circuit (14) and a switchable constant voltage source (16) which can each be used to adjust at least one criterion for evaluating the wake-up signal (WUP) that is present, wherein the comparator (12) is in the form of a multi-channel integrated comparator circuit (12A), wherein the individual channels of the integrated comparator circuit (12A) each evaluate one criterion of the wake-up signal (WUP) that is present, wherein the multi-channel integrated comparator circuit (12A) comprises an internal voltage source which generates a reference voltage, wherein a first voltage signal which is present at the input (In_A) of a first channel of the multi-channel integrated comparator circuit (12A) and which represents the amplitude of the wake-up signal (WUP) that is present is compared with the reference voltage, wherein a first criterion is met if the first voltage signal is greater than the reference voltage, and wherein a second voltage signal which is present at the input (In_B) of a second channel of the multi-channel integrated comparator circuit (12A) and which represents the duration of the wake-up signal (WUP) that is present is compared with the reference voltage, wherein a second criterion is met if the second voltage signal is greater than the reference voltage, **characterized in that** the multi-channel integrated comparator circuit (12A) changes a state at the output (Out_A) of the first channel if the first criterion is met, and wherein the change in state at the output (Out_A) of the first channel starts the evaluation of the second criterion.

2. Circuit (1) according to Claim 1, **characterized in that** the input circuit (14) uses an adjustable division ratio of a voltage divider (ST) to predefine the first criterion for evaluating an amplitude of the wake-up signal (WUP) that is present.

3. Circuit (1) according to Claim 1 or 2, **characterized in that** the input circuit (14) predefines an input impedance of the evaluation circuit (10).

4. Circuit (1) according to one of Claims 1 to 3, **characterized in that** the switchable constant voltage source (16) uses an adjustable time constant of an RC circuit (RL, C1, C2) to predefine the second criterion for evaluating a duration of the wake-up signal (WUP) that is present.

5. Circuit (1) according to Claim 4, **characterized in that** the wake-up signal (WUP) that is present switches on the constant voltage source (16).

6. Circuit (1) according to one of Claims 1 to 5, **characterized in that** the multi-channel integrated comparator circuit (12A) changes a state at the output (Out_B) of the second channel if the second criterion is met, wherein the change in state at the output (Out_B) of the second channel activates the output driver circuit (5) .

## Revendications

1. Circuit (1) destiné à traiter un signal de réveil (WUP), qui peut être utilisé pour activer des appareils électriques, ledit circuit comprenant un circuit d'évaluation (10) qui vérifie la validité d'un signal de réveil (WUP) appliqué, et un circuit pilote de sortie (5) qui délivre un signal de réveil traité (WUPA) lorsque le circuit d'évaluation (10) évalue le signal de réveil (WUP) appliqué comme valide, le circuit d'évaluation (10) comprenant un comparateur (12) qui compare le signal de réveil (WUP) appliqué à au moins une valeur seuil en vue de l'évaluation, le circuit d'évaluation (10) comprenant un circuit d'entrée (14) et une source de tension constante commutable (16) qui permettent de régler au moins un critère d'évaluation du signal de réveil (WUP) appliqué, le comparateur (12) étant conçu comme un circuit comparateur intégré multicanaux (12A), les canaux individuels du circuit comparateur intégré (12A) évaluant chacun un critère du signal de réveil (WUP) appliqué, le circuit comparateur intégré multicanaux (12A) comprenant une source de tension interne qui génère une tension de référence, un premier signal de tension qui est appliqué à l'entrée (In_A) d'un premier canal du circuit comparateur intégré multicanaux (12A) et qui représente l'amplitude du signal de réveil (WUP) appliqué étant comparé à la tension de référence, un premier critère étant satisfait lorsque le premier signal de tension est supérieur à la tension de référence, et un deuxième signal de tension qui est appliqué à l'entrée (In_B) d'un deuxième canal du circuit comparateur intégré multicanaux (12A) et qui représente la durée du signal de réveil (WUP) appliqué étant comparé à la tension de référence, un deuxième critère étant satisfait lorsque le deuxième signal de tension est supérieur à la tension de référence, **caractérisé en ce que** le circuit comparateur intégré multicanaux (12A) change d'état à la sortie (Out_A) du premier canal lorsque le premier critère est satisfait, et le changement d'état à la sortie (Out_A) du premier canal déclenchant l'évaluation du deuxième critère.

2. Circuit (1) selon la revendication 1, **caractérisé en ce que** le circuit d'entrée (14) spécifie le premier critère d'évaluation d'une amplitude du signal de réveil (WUP) appliqué par le biais d'un rapport de division réglable d'un diviseur de tension (ST).

3. Circuit (1) selon la revendication 1 ou 2, **caractérisé en ce que** le circuit d'entrée (14) spécifie une impédance d'entrée du circuit d'évaluation (10).

4. Circuit (1) selon l'une des revendications 1 à 3, **caractérisé en ce que** la source de tension constante commutable (16) spécifie le deuxième critère d'évaluation d'une durée du signal de réveil (WUP) appliqué par le biais d'une constante de temps réglable d'un circuit RC (RL, C1, C2).

5. Circuit (1) selon la revendication 4, **caractérisé en ce que** le signal de réveil (WUP) appliqué active la source de tension constante (16).

6. Circuit (1) selon l'une des revendications 1 à 5, **caractérisé en ce que** le circuit comparateur intégré multicanaux (12A) change d'état à la sortie (Out_B) du deuxième canal lorsque le deuxième critère est satisfait, le changement d'état à la sortie (Out_B) du deuxième canal activant le circuit pilote de sortie (5) .
